# EUROPEAN PATENT APPLICATION

(11) **EP 1 916 718 A1**
(43) Date of publication of application: **30.04.2008**
(21) Application number: 06780995.4
(22) Date of filing: 12.07.2006
(51) Int. Cl.: H01L 31/04

(54) **METHOD FOR MANUFACTURING PHOTOELECTRIC CONVERTER AND PHOTOELECTRIC CONVERTER**

(30) Priority: 01.08.2005 JP 2005222865
(71) Applicant: Sharp Kabushiki Kaisha, Osaka-shi, Osaka 545-8522 (JP)
(72) Inventor: JUSO, Hiroyuki, Nara 639-0223 (JP); YOSHIDA, Atsushi, Nara 639-1103 (JP); NAKAMURA, Kazuyo, Nara 639-0271 (JP); WASHIO, Hidetoshi, Nara 634-0006 (JP); TAKAHASHI, Naoki, Kyoto 619-0216 (JP); TAKAMOTO, Tatsuya, Nara 636-0821 (JP)
(74) Representative: Müller - Hoffmann & Partner
(86) International application number: PCT/JP2006/313825
(87) International publication number: WO 2007/015354

(57) **Abstract**

Disclosed is a method of manufacturing a photoelectric conversion element including a substrate (1) and a stacked body configured of a plurality of compound semiconductor layers (2, 3, 4) of different compositions sequentially stacked on the substrate (1), and having at least one pn junction in the stacked body. This method includes the steps of forming the stacked body configured of the plurality of compound semiconductor layers (2, 3, 4) of different compositions sequentially stacked on the substrate (1); forming a protective film (5) on the stacked body; forming a groove (8) by removing at least a portion of the stacked body by at least one method selected from the group consisting of a mechanical removing method, dry etching and laser scribing; etching a side wall of the groove (8) using an etching solution after forming the protective film (5) and the groove (8); and cutting a portion corresponding to the groove (8) for separation into a plurality of photoelectric conversion elements. Also disclosed is a photoelectric conversion element obtained by this method.

## Description

### TECHNICAL FIELD

The present invention relates to a method of manufacturing a photoelectric conversion element and the photoelectric conversion element, and particularly to a method of manufacturing a photoelectric conversion element that allows a reduction in the number of the steps of immersion in an etching solution and the number of the working processes, and a photoelectric conversion element obtained by this method of manufacturing the photoelectric conversion element.

### BACKGROUND ART

Generally, in the manufacture of a photoelectric conversion element such as a solar cell element, for the purpose of improving electric power to be generated, it is necessary to restrain carrier recombination at the end face of a pn junction to prevent decrease in parallel resistance of the photoelectric conversion element.

Conventionally, disclosed is a method of restraining carrier recombination at the end face of the pn junction in the photoelectric conversion element which has the pn junction formed within a stacked body comprised of a plurality of compound semiconductor layers formed on a substrate (for example, refer to Patent Document 1). This conventional method corresponds to a method of etching, by chemical treatment, the compound semiconductor layer in the boundary region (dividing region) dividing the photoelectric conversion element, and mechanically separating the remaining portion by dicing, to form individual photoelectric conversion elements.

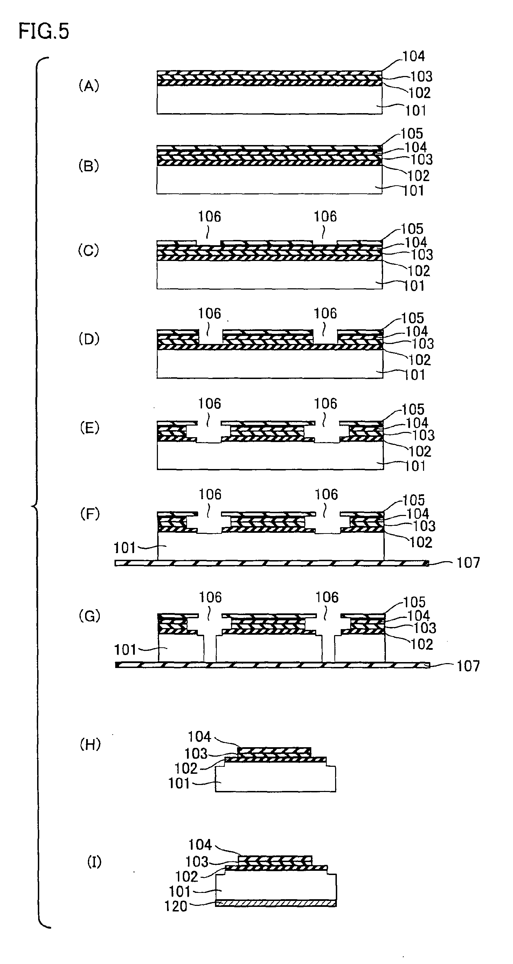

Figs. 5(A) to (I) each show a schematic cross sectional view illustrating an example of this conventional method (a method of a first conventional example). The method of the first conventional example is described below with reference to Figs. 5(A) to (I).

First, as shown in Fig. 5(A), a buffer layer 102, a base layer 103 and an emitter layer 104 which are compound semiconductor layers of different compositions are sequentially stacked on a substrate 101, to form a stacked body consisting of buffer layer 102, base layer 103 and emitter layer 104.

Then, as shown in Fig. 5(B), a protective film 105 such as photoresist which is resistant to the etching solution described below is formed on the surface of emitter layer 104 (protective film forming step).

As shown in Fig. 5(C), a portion of protective film 105 is removed for providing an opening, to form a cut-out portion 106 (patterning step) used for cutting each of substrate 101, buffer layer 102, base layer 103, and emitter layer 104 in a desired shape in the post step.

As shown in Fig. 5(D), base layer 103 and emitter layer 104 are removed using the etching solution with patterned protective film 105 used as a mask. Then, as shown in Fig. 5(E), substrate 101 and buffer layer 102 are removed using the etching solution (etching step).

As shown in Fig. 5(F), an adhesive sheet 107 is attached to the back side of substrate 101 (adhesive sheet attaching step).

Then, as shown in Fig. 5(G), substrate 101 is mechanically cut by dicing from cut-out portion 106 for separation to provide a chip state (cell state) which is the final shape (element separating step).

As shown in Fig. 5(H), the separated photoelectric conversion element in the chip state is detached from the adhesive sheet to remove the protective film on the surface (protective film peeling step).

Finally, as shown in Fig. 5(I), a backside electrode 120 is formed on the back side of substrate 101 of each photoelectric conversion element in the chip state (backside electrode forming step), and subsequently, heat treatment (heat treatment step) and characteristics measurement (element measurement step) are performed.

In the method of the first conventional example, however, if buffer layer 102 and emitter layer 104, each of which are, for example, a compound semiconductor layer, are made of material that can be etched by an etching solution A of the same composition, and substrate 101 and base layer 103 are made of material that can be etched by an etching solution B which is different in composition from etching solution A, in order to remove substrate 101, buffer layer 102, base layer 103, and emitter layer 104 by etching using the etching solution, it is necessary to etch emitter layer 104 by immersion in etching solution A to expose the surface of base layer 103, etch base layer 103 by immersion in etching solution B to expose the surface of buffer layer 102 (Fig. 5(D)), then etch buffer layer 102 by further immersion in etching solution A to expose the surface of substrate 101, and etch substrate 101 1 by further immersion in etching solution B (Fig. 5(E)).

Therefore, the method of the first conventional example requires the step of immersion in the etching solution to be performed four times in total, which poses a problem that the number of the steps of immersion in the etching solution is too many. Furthermore, in the method of the first conventional example, two times of immersion in each of etching solutions A and B causes an increase in the amount of etching base layer 103 and emitter layer 104 in the lateral direction, which poses a problem of deterioration in the characteristics of the photoelectric conversion element.

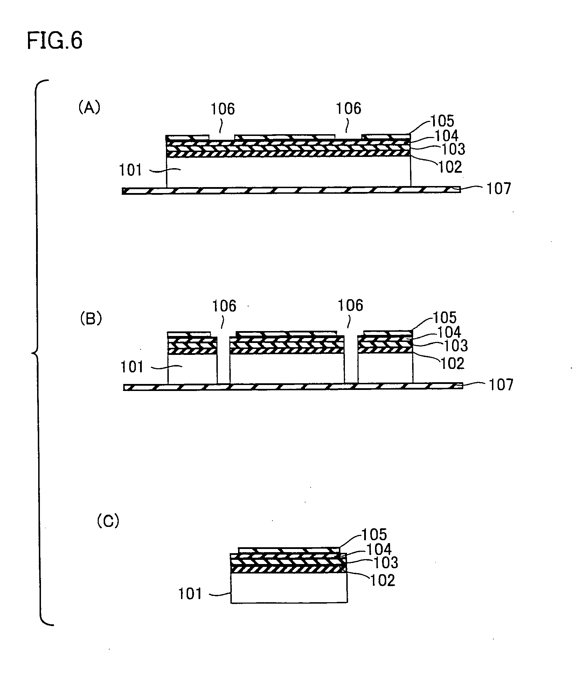

Furthermore, Figs. 6(A) to (C) each show a schematic cross sectional view illustrating part of another example of the method of manufacturing a photoelectric conversion element (a method of a second conventional example).

First, as in the method of the first conventional example, after the protective film forming step and the patterning step, adhesive sheet 107 is attached to the back side of substrate 101 as shown in Fig. 6(A) (adhesive sheet attaching step).

As shown in Fig. 6(B), substrate 101 is mechanically cut by dicing from cut-out portion 106 for separation to provide a chip state which is the final shape (element separating step). In this case, a peripheral portion of the photoelectric conversion element in the chip state has a region including crystal defect caused by the influence of dicing. This region becomes a factor of deterioration in the characteristics of the photoelectric conversion element.

As shown in Fig. 6(C), the photoelectric conversion element cut out in the chip state is detached from the adhesive tape and subjected to etching with protective film 105 used as a mask. This causes any layer including crystal defect in the peripheral portion to be removed, to allow the predetermined characteristics to be obtained (etching step).

Then, as in the method of the first conventional example, each of the photoelectric conversion elements is subjected to the protective film peeling step, the backside electrode forming step, the heat treatment step, and the element measurement step.

In the method of the above-described second conventional example, etching is performed from the side of the photoelectric conversion element cut out in the chip state. This eliminates the need of multiple steps of immersion in the same etching solution, which poses a problem in the method of the first conventional example, to thereby allow etching by a single immersion in each etching solution.

However, in the method of the second conventional example, it is necessary to perform the element separating step before the etching step, which requires each photoelectric conversion element in the chip state to be processed one by one in the steps after the element separating step. This causes an increase in the number of the working processes, which results in a decrease in yields and an increase in manufacturing cost.
Patent Document 1: Japanese Patent Laying-Open No. 8-274358

### DISCLOSURE OF THE INVENTION

### PROBLEMS TO BE SOLVED BY THE INVENTION

In consideration of the above, an object of the present invention is to provide a method of manufacturing a photoelectric conversion element that allows a reduction in the number of the steps of immersion in the etching solution and the number of the working processes, and a photoelectric conversion element obtained by the method of manufacturing thereof.

### MEANS FOR SOLVING THE PROBLEMS

The present invention provides a method of manufacturing a photoelectric conversion element including a substrate and a stacked body configured of a plurality of compound semiconductor layers of different compositions sequentially stacked on the substrate, and having at least one pn junction in the stacked body. The method includes the steps of forming the stacked body configured of the plurality of compound semiconductor layers of different compositions sequentially stacked on the substrate; forming a protective film on the stacked body; forming a groove by removing at least a portion of the stacked body by at least one method selected from the group consisting of a mechanical removing method, dry etching and laser scribing; etching a side wall of the groove using an etching solution after forming the protective film and the groove; and cutting a portion corresponding to the groove for separation into a plurality of photoelectric conversion elements.

In the method of manufacturing the photoelectric conversion element of the present invention, it is preferable that the groove is formed deeper than the pn junction located closest to the substrate at the time of formation of the groove.

Furthermore, in the method of manufacturing the photoelectric conversion element of the present invention, the mechanical removing method can be at least one of dicing and scribing.

Furthermore, in the method of manufacturing the photoelectric conversion element of the present invention, it is preferable that the groove width at the time of formation of the groove is greater than the cutting width at the time of separation into the plurality of photoelectric conversion elements.

Furthermore, in the method of manufacturing the photoelectric conversion element of the present invention, it is preferable that the groove width in the pn junction located closest to the substrate at the time of formation of the groove is greater than the cutting width at the time of separation into the plurality of photoelectric conversion elements.

In the method of manufacturing the photoelectric conversion element of the present invention, the groove can have a rectangular, V-shaped, U-shaped, or trapezoidal cross section.

In the method of manufacturing the photoelectric conversion element of the present invention, at least one of the compound semiconductor layers constituting the stacked body may include at least one of GaAs and GaP.

In the method of manufacturing the photoelectric conversion element of the present invention, at least one selected from the group consisting of an alkaline aqueous solution containing ammonia, an acidic aqueous solution containing sulfuric acid and an acidic aqueous solution containing hydrochloric acid can be used as the etching solution.

Furthermore, the present invention provides a photoelectric conversion element manufactured by any of the above-described methods of manufacturing the photoelectric conversion element, having a side wall of a groove in the peripheral portion thereof, and the side wall of the groove may be located inward relative to a portion other than the side wall of the groove in the peripheral portion.

### EFFECTS OF THE INVENTION

According to the present invention, a method of manufacturing a photoelectric conversion element that allows a reduction in the number of the steps of immersion in the etching solution and the number of the working processes, and a photoelectric conversion element obtained by this method of manufacturing the photoelectric conversion element can be provided.

### BRIEF DESCRIPTION OF THE DRAWINGS

Fig. 1 is a schematic cross sectional view illustrating a method of manufacturing a photoelectric conversion element according to a first embodiment of the present invention.
Fig. 2 is a schematic cross sectional view illustrating part of a method of manufacturing a photoelectric conversion element according to a second embodiment of the present invention.
Fig. 3 is a schematic cross sectional view illustrating part of a method of manufacturing a photoelectric conversion element according to a third embodiment of the present invention.
Fig. 4 is a schematic cross sectional view illustrating part of a method of manufacturing a photoelectric conversion element according to a fourth embodiment of the present invention.
Fig. 5 is a schematic cross sectional view illustrating a method of manufacturing a photoelectric conversion element of the first conventional example.
Fig. 6 is a schematic cross sectional view illustrating part of a method of manufacturing a photoelectric conversion element of the second conventional example.

### DESCRIPTION OF THE REFERENCE SIGNS

1, 101 substrate; 2, 102 buffer layer; 3, 103 base layer; 4, 104 emitter layer; 5, 105 protective film; 7, 107 adhesive sheet; 8 groove; 9 width; 10 etching region; 19 cutting width; 20, 120 backside electrode; 21 side wall of the groove; 22 portion other than the side wall of the groove; 23 angle; 106 cut-out portion.

### BEST MODES FOR CARRYING OUT THE INVENTION

The embodiments of the present invention will be hereinafter described. In the accompanying drawings of the present invention, the same or corresponding components are designated by the same reference characters.

### (First Embodiment)

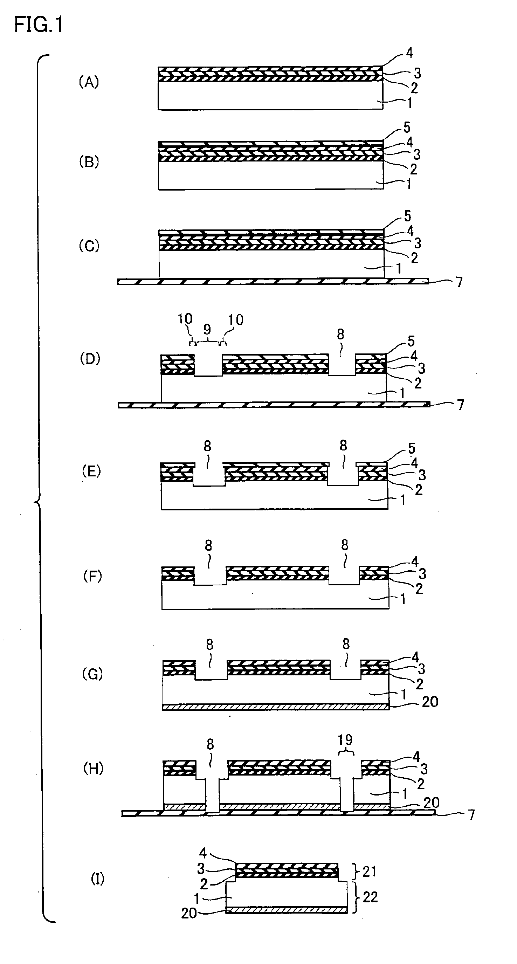

Figs. 1(A) to (I) each show a schematic cross sectional view of a method of manufacturing a photoelectric conversion element according to a first embodiment of the present invention. As shown in Fig. 1(A), a buffer layer 2, a base layer 3 and an emitter layer 4 formed of compound semiconductor layers of different compositions are sequentially stacked on a substrate 1, to form a stacked body comprised of buffer layer 2, base layer 3 and emitter layer 4. Substrate 1 is, for example, in the form of a wafer, and buffer layer 2, base layer 3 and emitter layer 4 can be formed on substrate 1 in the well-known processes, respectively.

For example, the semiconductor substrate formed of any of InGaAs, InGaP, Ge, GaP or GaAs, or, the semiconductor substrate configured of a stack of at least two or more types of layers selected from the group consisting of InGaAs, InGaP, Ge, GaP or GaAs can be used as substrate 1. Furthermore, the thickness of substrate 1 is not specifically limited, and, for example, the thickness causing no problem in practical use can be used. Substrate 1 may have a pn junction.

Furthermore, the stacked body is configured of a three-layered structure consisting of buffer layer 2, base layer 3 and emitter layer 4 but is not limited to this structure, and only needs to be configured of a stack of two or more compound semiconductor layers, for example, as in the two-layered or four-layered structure. In addition to buffer layer 2, base layer 3 and emitter layer 4, at least one or more compound semiconductor layers such as a BSF (Back Surface Field) layer, a window layer, a tunnel junction layer of a multijunction type photoelectric conversion element, another base layer and emitter layer of the multijunction type photoelectric conversion element, and the like may be included.

For example, a GaAs layer, an InGaAs layer, an InAlP layer, an InGaP layer, or a GaP layer can be used as a compound semiconductor layer.

Furthermore, the stacked body only needs to be configured of a plurality of compound semiconductor layers of different compositions sequentially stacked, in which the pn junction only needs to be formed by the plurality of compound semiconductor layers. It is to be noted that the pn junction in the stacked body can be formed by joining a p-type compound semiconductor layer and an n-type compound semiconductor layer. Furthermore, the plurality of compound semiconductor layers may include a first compound semiconductor layer in which the etching rate at the time of immersion in a first etching solution is higher than the etching rate at the time of immersion in a second etching solution (which is different in composition from the first etching solution), and a second compound semiconductor layer in which the etching rate at the time of immersion in the above-mentioned second etching solution is higher than the etching rate at the time of immersion in the above-mentioned first etching solution.

Then, as shown in Fig. 1(B), a protective film 5 is formed on emitter layer 4 which corresponds to the outermost surface of the stacked body consisting of buffer layer 2, base layer 3 and emitter layer 4 (protective film forming step). In this case, protective film 5 only needs to be resistant to the respective etching solutions for etching each of buffer layer 2, base layer 3 and emitter layer 4 in the subsequent step. It is preferable that photoresist is used as protective film 5 because it facilitates etching in the subsequent step.

As shown in Fig. 1(C), an adhesive sheet 7 is attached to the back side of substrate 1 (the surface on the opposite side of the surface on which the compound semiconductor layers are stacked) (adhesive sheet attaching step). Adhesive sheet 7 only needs to maintain the strength of substrate 1, for example. It is to be noted that there is no need to perform this adhesive sheet attaching step depending on the method of performing the groove forming step described below.

Then, as shown in Fig. 1(D), a portion of each of substrate 1, buffer layer 2, base layer 3, emitter layer 4, and protective film 5 is mechanically removed by dicing to form a groove 8 having a rectangular cross section (groove forming step). It is preferable that this groove 8 is formed in consideration of the predetermined final shape of the photoelectric conversion element.

Furthermore, it is preferable that groove 8 is formed, at the time of formation thereof, deeper than the pn junction located closest to substrate 1 in consideration of reliable separation of the photoelectric conversion element. The pn junction located closest to substrate 1 corresponds to the part located closest to substrate 1 in the pn junction included in the stacked body in the case where substrate 1 does not include the pn junction, and it corresponds to the pn junction located closest to the back side of substrate 1 (the surface on the opposite side of the surface on which the compound semiconductor layers are stacked) in the case where substrate 1 includes the pn junction. Thus, the pn junction included in the stacked body and/or substrate 1 is cut along this groove 8. However, if groove 8 is formed too deep, there is a tendency that the strength of substrate 1 is decreased and the photoelectric conversion elements cannot be kept coupled to each other. It is confirmed by experiment that, when the thickness of substrate 1 is, for example, 100-200 µm, it is preferable that the amount of cutting substrate 1 is set to be 20-50 µm. It is to be noted that the stacked body consisting of buffer layer 2, base layer 3 and emitter layer 4 is divided by this groove forming step. Protective film 5 is also divided in the shape similar to that of the stacked body.

Furthermore, it is preferable that a width 9 of groove 8 is set such that the pn junction of the photoelectric conversion element is not influenced by cutting such as dicing performed in the element separating step described below. In other words, it is preferable that width 9 of groove 8 in the pn junction located closest to substrate 1 is greater than the cutting width (a cutting width 19 shown in Fig. 1(H)) by dicing and the like performed in the element separating step described below. It is confirmed by experiment that, for example, when a dicing blade having a width of 20 µm is used in the element separating step described below, it is preferable that width 9 of groove 8 is set to be not less than 40 µm in consideration of the alignment accuracy and the like of dicing equipment.

It is to be noted that the groove forming step can be performed, for example, by at least one selected from the group consisting of dicing, scribing, dry etching, and laser scribing.

An etching region 10 etched in the etching step described below is formed on the side wall of groove 8. At the time of formation of groove 8, a region containing many crystal defects is formed in the stacked body and substrate 1 under mechanical and/or thermal influence, in which carrier recombination occurs greatly, to thereby cause the characteristics of the photoelectric conversion element to deteriorate. Accordingly, etching region 10 in the side wall of groove 8 is removed in the etching step.

After the groove forming step, as shown in Fig. 1 (E), adhesive sheet 7 is peeled off from substrate 1, substrate 1 on which the stacked body is formed is immersed in the etching solution, and etching region 10 is removed by etching with protective film 5 used as an etching mask (etching step).

In the present embodiment, even if the etching solutions suitable for etching each of substrate 1, buffer layer 2, base layer 3, and emitter layer 4 are different in composition, those etched by the etching solution of the same composition are etched simultaneously from the side wall of groove 8 regardless of their positions. This eliminates the need of multiple steps of immersion in the etching solution of the same composition, which is required in the above-described first conventional example.

For example, even if buffer layer 2 and emitter layer 4 are made of material that can be etched by the first etching solution but cannot be etched by the second etching solution which is different in composition from the first etching solution, and substrate 1 and base layer 3 are made of material that can be etched by the above-mentioned second etching solution but cannot be etched by the above-mentioned first etching solution, only a single immersion in each of the first etching solution and the second etching solution allows etching of etching region 10 in the side wall of groove 8.

Furthermore, in the present embodiment, the etching step can be performed in the state where the photoelectric conversion elements are coupled to each other, which allows the etching processes to be collectively performed. Therefore, there is no need of separate etching of the photoelectric conversion elements as in the above-described second conventional example, which allows the number of the working processes to be greatly reduced.

In the etching step, it is preferable to select the composition of the etching solution and the duration of the etching process, as appropriate, depending on the types of the compound semiconductor layer and the substrate existing in etching region 10 in the side wall of groove 8. For example, in the case where the compound semiconductor layer includes an InGaAs layer, a GaAs layer or the like, and/or the substrate includes an InGaAs substrate, a GaAs substrate, a Ge substrate or the like, it is preferable to use, as an etching solution, an alkaline aqueous solution containing ammonia and/or an acidic aqueous solution containing sulfuric acid.

The composition of the alkaline aqueous solution containing ammonia can be set, for example, to be NH₄OH:H₂O₂:H₂O=1:1:10 (volume ratio), and the duration of the etching process using the alkaline aqueous solution containing ammonia can be set, for example, to be 60 seconds to 90 seconds.

Furthermore, the composition of the acidic aqueous solution containing sulfuric acid can be set, for example, to be H₂SO₄:H₂O₂:H₂O=1:1:10 (volume ratio), and the duration of the etching process using the acidic aqueous solution containing sulfuric acid can be set to be 60 seconds to 90 seconds.

For example, in the case where the compound semiconductor layer includes an InGaP layer, an GaP layer or the like, or the substrate includes an InGaP substrate, a GaP substrate or the like, it is preferable to use an acidic aqueous solution containing hydrochloric acid as an etching solution.

The composition of the acidic aqueous solution containing hydrochloric acid can be set, for example, to be HCl:H₂O₂:H₂O=1:1:10 (volume ratio), and the duration of the etching process using the composition of the acidic aqueous solution containing hydrochloric acid can be set, for example, to be 60 seconds to 90 seconds.

After the above-described etching step, protective film 5 is peeled off as shown in Fig. 1(F) (protective film peeling step).

As shown in Fig. 1 (G), a backside electrode 20 is formed on the back side of substrate 1, for example, using an electrode forming apparatus (backside electrode forming step). Then, heat treatment is performed for the purpose of improving physical adhesion properties between substrate 1 and backside electrode 20, and reducing electrical resistance (heat treatment step). After the heat treatment step, substrate 1 is placed in a measurement apparatus to evaluate the characteristics of the photoelectric conversion element (element measurement step).

The protective film peeling step, the backside electrode forming step, the heat treatment step, and the element measurement step can be performed in the state where the plurality of photoelectric conversion elements are coupled to each other. Therefore, the number of the working processes can be greatly reduced as compared to the above-described second conventional example in which a series of the protective film peeling step, the backside electrode forming step, the heat treatment step, and the element measurement step is performed for each of the separated photoelectric conversion elements. For example, when one hundred photoelectric conversion elements are produced from one substrate, each duration of the protective film peeling step, the backside electrode forming step, the heat treatment step, and the element measurement step can be reduced to 1/100 in the present embodiment, as compared to the above-described second conventional example.

It is to be noted that at least one of the backside electrode forming step and the heat treatment step may be performed before the above-described protective film forming step.

After the element measurement step, as shown in Fig. 1(H), adhesive tape 7 is attached to the back side of substrate 11 (adhesive sheet attaching step), and the portion corresponding to groove 8 formed in the above-mentioned groove forming step is cut by dicing and the like for separation into a plurality of photoelectric conversion elements (element separating step). This allows the photoelectric conversion element in a chip state (cell state) to be produced. As described above, it is preferable that cutting width 19 is narrower than width 9 of groove 8 at the time of groove formation.

Finally, adhesive tape 7 is peeled off, to thereby allow each photoelectric conversion element cut in the predetermined shape to be obtained, as shown in Fig. 1 (I) (element detaching step).

A peripheral portion of this photoelectric conversion element includes a side wall 21 of the groove obtained through the groove forming step and the etching step and a portion 22 other than the side wall of the groove obtained in the element separating step. Side wall 21 of the groove is located inward relative to portion 22 other than the side wall of the groove. The pn junction of the photoelectric conversion element is located at the height corresponding to any part of side wall 21 of the groove.

When each photoelectric conversion element is processed after the element separating step, if the pn junction of the photoelectric conversion element is mechanically damaged, the characteristics of the photoelectric conversion element become deteriorated. However, the pn junction of the photoelectric conversion element shown in Fig. 1(I) is located at the height corresponding to any part of side wall 21 of the groove located inward relative to portion 22 other than the side wall of the groove, which reduces the possibility of mechanical damage caused by handling and the like. This can reduce the possibility of deteriorating the characteristics of the photoelectric conversion element.

The photoelectric conversion element obtained by this manufacturing method of the present embodiment can be used as a solar cell element by suitably adjusting substrate 1, buffer layer 2, base layer 3, and emitter layer 4.

### (Second Embodiment)

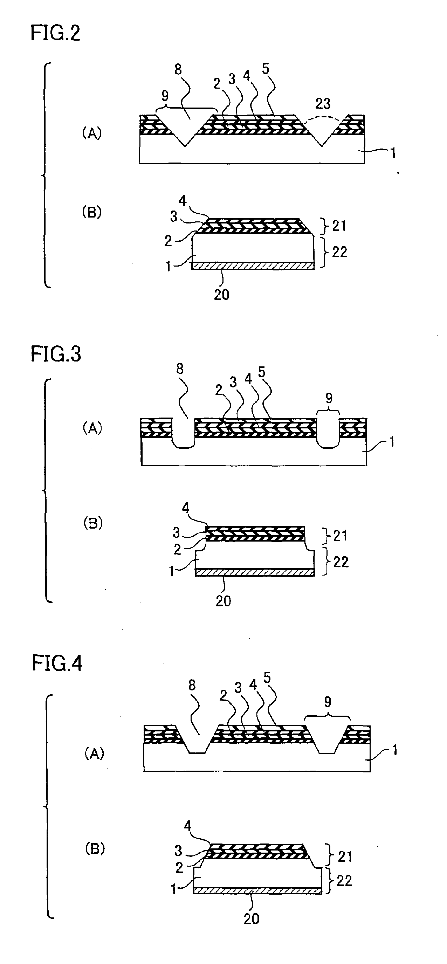

Figs. 2(A) and (B) each show a schematic cross sectional view of part of a method of manufacturing a photoelectric conversion element according to a second embodiment of the present invention.

While the first embodiment describes the groove formed in the groove forming step having a rectangular cross section, the second embodiment describes the groove characterized by having a V-shaped cross section as shown in Fig. 2(A). Other steps are the same as those in the first embodiment.

A V-shaped angle 23 is not specifically limited. However, if V-shaped angle 23 is set to be too large, width 9 of groove 8 becomes too wide, which may result in deterioration of the characteristics of the photoelectric conversion element. If V-shaped angle 23 is set to be too small, the effect of the groove formation may not be achieved. Therefore, it is preferable that V-shaped angle 23 is set to be not less than 30° and not more than 60 °.

In the case where the groove has a V-shaped cross-section as in the present embodiment, the peripheral portion of the photoelectric conversion element after separation in the element separating step includes a side wall 21 of the groove having an inclination resulting from the V-shaped groove and a portion 22 other than the side wall of the groove, as shown in Fig. 2(B). Side wall 21 of the groove is located inward relative to portion 22 other than the side wall of the groove.

In this way, also in the present embodiment, side wall 21 of the groove is located inward relative to portion 22 other than the side wall of the groove. This can produce the effect of reducing the possibility that the pn junction is mechanically damaged after the element detaching step, as in the first embodiment.

### (Third Embodiment)

Figs. 3(A) and (B) each show a schematic cross sectional view of part of a method of manufacturing a photoelectric conversion element according to a third embodiment of the present invention.

While the first embodiment describes the groove formed in the groove forming step having a rectangular cross section, the third embodiment describes the groove characterized by having a U-shaped cross section as shown in Fig. 3(A). Other steps are the same as those in the first embodiment.

Also in the case where the groove has a U-shaped cross section as in the present embodiment, the peripheral portion of the photoelectric conversion element after separation in the element separating step includes a side wall 21 of the groove and a portion 22 other than the side wall of the groove obtained in the element separating step, as shown in Fig. 3(B). Side wall 21 of the groove is located inward relative to portion 22 other than the side wall of the groove.

In this way, also in the present embodiment, side wall 21 of the groove is located inward relative to portion 22 other than the side wall of the groove. This can produce the effect of reducing the possibility that the pn junction is mechanically damaged after the element detaching step, as in the first embodiment.

### (Fourth Embodiment)

Figs. 4(A) and (B) each show a schematic cross sectional view of part of a method of manufacturing a photoelectric conversion element according to a fourth embodiment of the present invention.

While the first embodiment describes the groove formed in the groove forming step having a rectangular cross section, the fourth embodiment describes the groove characterized by having a trapezoidal cross section as shown in Fig. 4(A). Other steps are the same as those in the first embodiment.

Also in the case where the groove has a trapezoidal cross section as in the present embodiment, the peripheral portion of the photoelectric conversion element after separation in the element separating step includes a side wall 21 of the groove and a portion 22 other than the side wall of the groove obtained in the element separating step, as shown in Fig. 4(B). Side wall 21 of the groove is located inward relative to portion 22 other than the side wall of the groove.

In this way, also in the present embodiment, side wall 21 of the groove is located inward relative to portion 22 other than the side wall of the groove. This can produce the effect of reducing the possibility that the pn junction is mechanically damaged after the element detaching step, as in the first embodiment.

It should be understood that the embodiments disclosed herein are illustrative and non-restrictive in every respect. The scope of the present invention is defined by the terms of the claims, rather than the description above, and is intended to include any modifications within the scope and meaning equivalent to the terms of the claims.

### INDUSTRIAL APPLICABILITY

The present invention can be suitably used for manufacturing a solar cell element, particularly for manufacturing a compound semiconductor solar cell element.

## Claims

1. A method of manufacturing a photoelectric conversion element including a substrate (1) and a stacked body configured of a plurality of compound semiconductor layers (2, 3, 4) of different compositions sequentially stacked on the substrate (1), and having at least one pn junction in the stacked body, comprising the steps of:
forming the stacked body configured of the plurality of compound semiconductor layers (2, 3, 4) of different compositions sequentially stacked on the substrate (1);
forming a protective film (5) on the stacked body;
forming a groove (8) by removing at least a portion of the stacked body by at least one method selected from the group consisting of a mechanical removing method, dry etching and laser scribing;
etching a side wall of the groove (8) using an etching solution after forming the protective film (5) and the groove (8); and
cutting a portion corresponding to the groove (8) for separation into a plurality of photoelectric conversion elements.

2. The method of manufacturing the photoelectric conversion element according to claim 1, wherein the groove (8) is formed deeper than the pn junction located closest to the substrate (1) at the time of formation of the groove (8).

3. The method of manufacturing the photoelectric conversion element according to claim 1, wherein the mechanical removing method is at least one of dicing and scribing.

4. The method of manufacturing the photoelectric conversion element according to claim 1, wherein a groove width (9) at the time of formation of the groove (8) is greater than a cutting width (19) at the time of separation into the plurality of photoelectric conversion elements.

5. The method of manufacturing the photoelectric conversion element according to claim 4, wherein the groove width (9) in the pn junction located closest to the substrate (1) at the time of formation of the groove (8) is greater than the cutting width (19) at the time of separation into the plurality of photoelectric conversion elements.

6. The method of manufacturing the photoelectric conversion element according to claim 1, wherein the groove (8) has a rectangular, V-shaped, U-shaped, or trapezoidal cross section.

7. The method of manufacturing the photoelectric conversion element according to claim 1, wherein at least one of the compound semiconductor layers (2, 3, 4) constituting the stacked body includes at least one of GaAs and GaP.

8. The method of manufacturing the photoelectric conversion element according to claim 1, wherein at least one selected from the group consisting of an alkaline aqueous solution containing ammonia, an acidic aqueous solution containing sulfuric acid and an acidic aqueous solution containing hydrochloric acid is used as the etching solution.

9. A photoelectric conversion element manufactured by the method of manufacturing the photoelectric conversion element according to claim 1, having a side wall (21) of a groove (8) in a peripheral portion, the side wall (21) of the groove (8) being located inward relative to a portion (22) other than the side wall of the groove (8) in the peripheral portion.
